# EUROPÄISCHE PATENTANMELDUNG

(11) **EP 0 847 134 A1**
(43) Veröffentlichungstag der Anmeldung: **10.06.1998**
(21) Anmeldenummer: 97113373.1
(22) Anmeldetag: 02.08.1997
(51) Int. Cl.: H03F 1/32

(54) **Schaltung zur Linearisierung eines Verstärkers**

(30) Priorität: 05.12.1996 DE 19650388
(71) Anmelder: ROBERT BOSCH GMBH, 70442 Stuttgart (DE)
(72) Erfinder: Mück, Karl, 07158 Sulzbach an der Murr (DE)

(57) **Zusammenfassung**

Um bei einem Feed-Forward-Verstärker mit einem Fehlersignalverstärker (V3) auszukommen, der einen nur geringen linearen Aussteuerbereich benötigt und daher mit einem geringen Schaltungsaufwand realisierbar ist, ist dem Verstärker (V1) ein Vorverzerrer (VVZ) vorgeschaltet, und es ist eine Steuereinheit (ST1) vorhanden, die beim Betrieb des Verstärkers (V1) im nichtlinearen Aussteuerbereich den Vorverzerrer (VVZ) in Abhängigkeit von einem Fehlersignal (f1) so einstellt, daß das Fehlersignal (f1), das dem Fehlersignalverstärker (V3) zugeführt wird, minimal wird.

## Beschreibung

### Stand der Technik

Die vorliegende Erfindung betrifft eine Schaltung zur Linearisierung eines Verstärkers, welcher einen Fehlersignalverstärker aufweist, der ein aus dem Ein- und dem Ausgangssignal des Verstärkers abgeleitetes Fehlersignal verstärkt, das dem Ausgangssignal zur Kompensation der darin enthaltenen Intermodulationsprodukte überlagert wird.

Ein derartiger Verstärker, der in der Literatur als Feed-Forward-Verstärker bezeichnet wird, ist beispielsweise aus IEEE-Transactions on Microwave Theorie and Techniques, Vol. 42, No. 6, June 1994, Seite 1086 bis 1087, bekannt.

Beispielsweise für die beim digitalen Richtfunk verwendete Modulationsart QAM werden sehr große Forderungen an die Linearität eines Sendeverstärkers gestellt. Je höher die Anzahl der Modulationsstufen (16, 64, 128, 256, 512 QAM) ist, desto höhere Anforderungen sind an die Linearität des Verstärkers zu stellen. Für die höheren Modulationsstufen 256 und 512 QAM steigt auch noch die Sendeleistung, damit bei gleicher Funkfeldlänge ein größerer Signal-Rauschabstand erreicht wird.

Es ist das Ziel, mit möglichst wenigen Verstärkerstufen auskommen zu können. Deshalb ist man bestrebt, jeden Verstärker möglichst weit auszusteuern, d.h. die Spitzenaussteuerung bis nahe an den 1dB-Kompressionspunkt heranzuführen. Damit wird der Verstärker nicht nur in seinem linearen, sondern auch in seinem nichtlinearen Bereich betrieben. Um trotzdem im Ausgangssignal des Verstärkers einen genügend großen Intermodulationsabstand zu erreichen, wird die oben angesprochene Linearisierung des Verstärkers vorgenommen. Der bei den Feed-Forward-Verstärkern verwendete Fehlersignalverstärker darf natürlich nur in seinem linearen Aussteuerbereich betrieben werden, so daß er nicht noch zusätzliche Intermodulationsprodukte erzeugt. Von diesem Fehlersignalverstärker wird dann aber, insbesondere wenn die Fehlersignale groß sind, ein großer linearer Aussteuerbereich verlangt. Ein Fehlersignalverstärker mit einem großen linearen Aussteuerbereich, d.h. also einem hohen 1dB-Kompressionspunkt, ist relativ aufwendig zu realisieren, weshalb ein solcher Verstärker teuer wird. Auch würde ein solcher Fehlerverstärker eine relativ hohe Verlustleistung erzeugen.

Der Erfindung liegt daher die Aufgabe zugrunde, eine Schaltung der eingangs genannten Art anzugeben, welche mit einem möglichst wenig aufwendigen Fehlerverstärker auskommt.

### Vorteile der Erfindung

Mit den Merkmalen des Anspruchs 1 wird die genannte Aufgabe dadurch gelöst, daß dem Verstärker ein Vorverzerrer vorgeschaltet ist und daß eine Steuereinheit vorhanden ist, die beim Betrieb des Verstärkers im nichtlinearen Aussteuerbereich den Vorverzerrer in Abhängigkeit vom Fehlersignal so einstellt, daß das Fehlersignal minimal wird. Je kleiner das Fehlersignal ist, ein desto geringerer linearer Aussteuerbereich des Fehlersignalverstärkers ist erforderlich. Ein Fehlersignalverstärker mit einem kleinen linearen Aussteuerbereich ist mit geringem Schaltungsaufwand realisierbar.

Vorteilhafte Weiterbildungen der Erfindung gehen aus den Unteransprüchen hervor. So kann die Steuereinheit beim Betrieb des Verstärkers im linearen Aussteuerbereich den Betrag und die Phase eines vom Eingangssignal ausgekoppelten Signalanteils in Abhängigkeit von der Differenz zwischen dem Ausgangs- und dem Eingangssignalanteil des Verstärkers so einstellen, daß der Nutzsignalanteil in dem Differenzsignal zwischen dem Ausgangs- und dem Eingangssignalanteil möglichst gering ist.

Die zuvor genannte Steuereinheit oder auch eine davon getrennte zweite Steuereinheit stellt den Betrag und die Phase des Fehlersignals so ein, daß es durch Überlagerung des Fehlersignals mit dem Ausgangssignal des Verstärkers zu einer größtmöglichen Kompensation der Intermodulationsprodukte im Ausgangssignal kommt. Dabei stellt die Steuereinheit den Betrag und die Phase des Fehlersignals in Abhängigkeit von der Differenz zwischen einem vom Eingangssingal des Verstärkers ausgekoppelten Signalanteil und einem von fehlerkompensierten Ausgangssignal des Verstärkers ausgekoppelten Signalanteil ein. Und zwar stellt die Steuereinheit den Betrag und die Phase des vom fehler-kompensierten Ausgangssignal ausgekoppelten Signalanteil so ein, daß der Nutzsignalanteil in dem Differenzsignal möglichst gering ist. Ein Mischer mischt das Differenzsignal in eine Zwischenfrequenzebene herunter, und dieses Signal wird dann über einen Spektrumdetekor zur Selektion von Spektralanteilen zu beiden Seiten des Nutzsignalspektrums der Steuereinheit zugeführt.

### Beschreibung von Ausführungsbeispielen

Anhand mehrerer in der Zeichnung dargestellter Ausführungsbeispiele wird nachfolgend die Erfindung näher erläutert. Es zeigen:
Figur 1 eine Schaltung zur Linearisierung des Ausgangssignals eines Verstärkers,
Figuren 2 und 3 Verstärkerkennlinien und Intermodulationskennlinien und
Figur 4 eine gegenüber den Figur 1 abgewandelte Schaltung zur Linearisierung des Ausgangssignals eines Verstärkers.

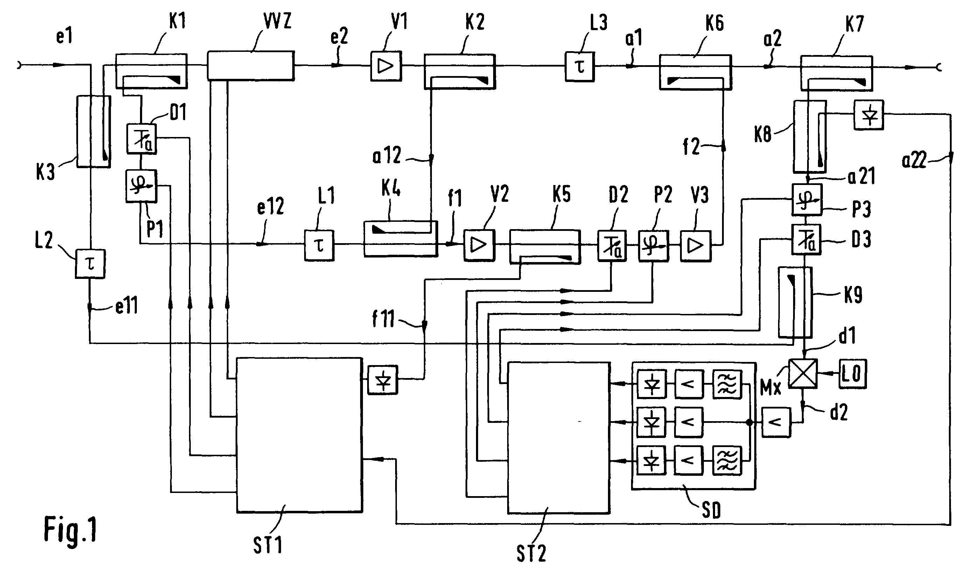

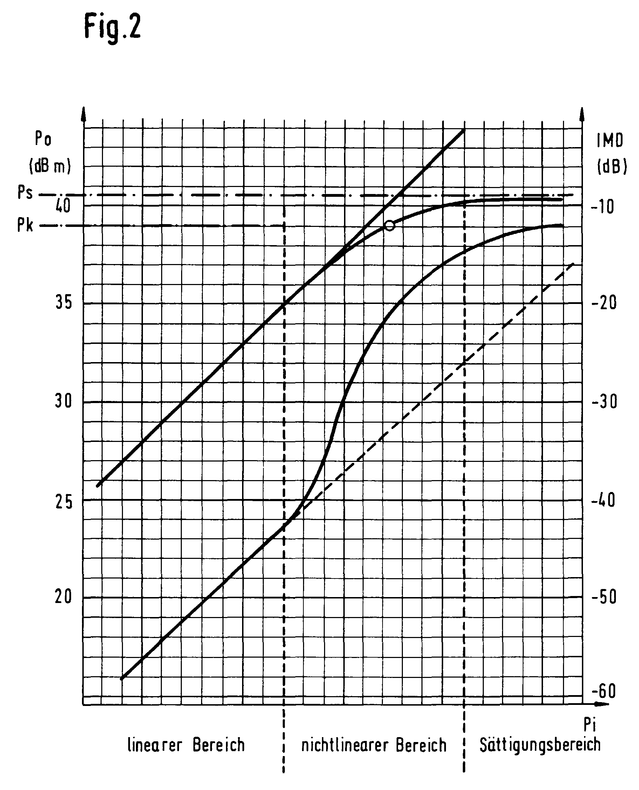

Die in Figur 1 dargestellte Schaltung dient zur Linearisierung des Verstärkers V1. Eine übliche Kennlinie eines Halbleiterverstärkers, welche die Abhängigkeit der Ausgangsleistung Po von der Eingangsleistung Pi wiedergibt, ist der Figur 2 (obere Kennlinie) zu entnehmen. Eine solche Verstärkerkennlinie weist im wesentlichen drei Aussteuerbereiche auf, nämlich einen linearen, einen nichtlinearen und einen Sättigungsbereich. Charakteristisch für eine solche Verstärkerkennlinie ist der 1dB-Kompressionspunkt Pk, bei dem die Verstärkung durch Kompression um 1dB kleiner wird. Die Sättigungsleistung Ps des Verstärkers liegt etwa 1 bis 1,5dB über dem 1dB-Kompressionspunkt Pk. Auch bereits im linearen Aussteuerbereich, in dem die Ausgangssignalleistung Po proportional zur Eingangssignalleistung Pi ist, können leichte Krümmungen der Kennlinie auftreten, welche bereits Intermodulationsprodukte höherer, ungerader Ordnung erzeugen. Diese Intermodulationsprodukte fallen in das Spektrum des Nutzsignals und verursachen ab einer bestimmten Größe Bitfehler. Im nichtlinearen Aussteuerbereich des Verstärkers tritt durch eine Großsignalaussteuerung eine zusätzliche Krümmung durch die genannte Kompression auf, die eine zusätzliche Verkleinerung des Intermodulationsabstandes zur Folge hat. Die untere Kennlinie in Figur 2, welche den Intermodulationsabstand IMD darstellt, verdeutlicht den Effekt, daß der Intermodulationsabstand im nichtlinearen Bereich des Verstärkers erheblich zunimmt.

Zur Linearisierung des Verstärkers V1 wird gemäß der in Figur 1 dargestellten Schaltung aus dem Eingangssignal e1 und dem Ausgangssignal a1 des Verstärkers V1 ein Fehlersignal f1 abgeleitet, das durch den Fehlersignalverstärker V3 verstärkt und dem Ausgangssignal a1 des Verstärkers V1 überlagert wird, so daß die darin vorhandenen Intermodulationsprodukte weitestgehend kompensiert werden. Dazu wird aus dem Eingangssignal e1 über den Koppler K1 ein Signal e12 ausgekoppelt und über einen Koppler K2 wird aus dem nicht linearisierten Ausgangssignal a1 des Verstärkers V1 ein Signalanteil a12 ausgekoppelt. Der Eingangssignalanteil e12 wird nach einem Laufzeitausgleich durch das Laufzeitglied L1 einem Koppler K4 zugeführt. Ebenfalls liegt an dem Koppler K4 der Ausgangssignalanteil a12 an. Das Ausgangssignal des Kopplers K4, welches der Differenz zwischen dem Ausgangssignalanteil a12 und dem Eingangssignalanteil e12 entspricht, ist das Fehlersignal f1. Nach einer Vorverstärkung V2 und einer später noch detailliert beschriebenen Dämpfungs- D2 und Phasenregelung P2 gelangt das Fehlersignal f1 an den Fehlersignalverstärker V3, dessen Ausgangssignal f2 schließlich von einem Koppler K6 dem Ausgangssignal a1 des Verstärkers V1 überlagert wird. Dadurch kommt es zu einer Kompensation der im Ausgangssignal a1 des Verstärkers V1 vorhandenen Intermodulationsprodukte. Am Ausgang des Kopplers K6 steht somit ein linearisiertes Ausgangssignal a2, dessen Intermodulationsabstand gegenüber dem Signal a1 erheblich vergrößert ist, zur Verfügung. Das Laufzeitglied L3 vor dem Koppler K6 bewirkt, daß die Signale a1 und f2 zeitrichtig überlagert werden, so daß es zu einer optimalen Kompensation der Intermodulationsprodukte im Ausgangssignal a1 kommt.

Um am Ausgang des Kopplers K4 ein Fehlersignal f1 zu erhalten, das hauptsächlich von den Intermodulationsprodukten im Ausgangssignal a1 des Verstärkers V1 bestimmt ist und in dem Nutzsignalanteile möglichst weitgehend reduziert sind, werden der Betrag und die Phase des Eingangssignalanteils e12 über ein variables Dämpfungsglied D1 und ein variables Phasenglied P1 so eingestellt, daß Betrag und Phase des Nutzsignalanteils in dem Eingangssignalanteil e12 gleich ist dem Nutzsignalanteil im Ausgangssignalanteil a12. Durch Differenzbildung zwischen dem Eingangssignalanteil e12 und dem Ausgangssignalanteil a12 im Koppler K4 verschwindet dann der Nutzsignalanteil und im Fehlersighal f1 bleiben nur noch die Interpolationsprodukte übrig.

Die Steuerung des Dämpfungsgliedes D1 und des Phasengliedes P1 übernimmt eine Steuereinheit ST1. Diese Steuereinheit ST1 erhält einen über einen Koppler K5 ausgekoppelten Signalanteil f11 des Fehlersignals f1. In Abhängigkeit von diesem Fehlersignalanteil f11 steuert die Steuereinheit ST1 das Dämpfungsglied D1 und das Phasenglied P1 so, daß der Nutzsignalanteil im Fehlersignal f1 möglichst gering wird.

Wie der Schaltung in Figur 1 zu entnehmen ist, ist dem Verstärker V1 ein Vorverzerrer VVZ vorgeschaltet. Bei großen Ausgangssighalpegeln, d.h. wenn der Verstärker V1 im nichtlinearen Aussteuerbereich betrieben wird und deshalb wegen hoher Intermodulationsprodukte das Fehlersignal f1 sehr groß wird, stellt die Steuereinheit ST1 die Übertragungsfunktion des Vorverzerrers VVZ so ein, daß das Fehlersignal f1 möglichst klein bleibt. Durch die Vorverzerrung wird also bereits für eine gewisse Linearisierung des Verstärkerausgangssignals a1 gesorgt, wodurch das Fehlersignal f1 einen geringeren Pegel aufweist, obwohl der Verstärker sich in seinem nichtlinearen Aussteuerbereich befindet. Das hat den Vorteil, daß der Fehlersignalverstärker V3 keinen großen linearen Aussteuerbereich aufweisen muß. Wie bereits oben gesagt, kann ein solcher Fehlersignalverstärker V3 mit einem geringen Schaltungsaufwand realisiert werden.

Die Steuereinheit ST1 steuert den Amplituden- und den Phasengang des Vorverzerrers VVZ so, daß das Fehlersignal f1 möglichst gering wird. Als Regelgröße dafür verwendet die Steuereinheit ST1 wiederum den über den Koppler K5 ausgekoppelten Fehlersignalanteil f11. Die Steuereinheit ST1 erhält als weiteres Eingangssignal einen aus dem linearisierten Ausgangssignal a2 über die Koppler K7 und K8 ausgekoppelten Signalanteil a22. Über dieses Signal a22 erhält die Steuereinheit ST1 die Information, ob der Ausgangssignalpegel des Verstärkers V1 groß ist und er sich damit im nichtlinearen Aussteuerbereich befindet. Denn nur dann soll der Vorverzerrer VVZ zur Minimierung des Fehlersignals f1 wirksam geschaltet werden.

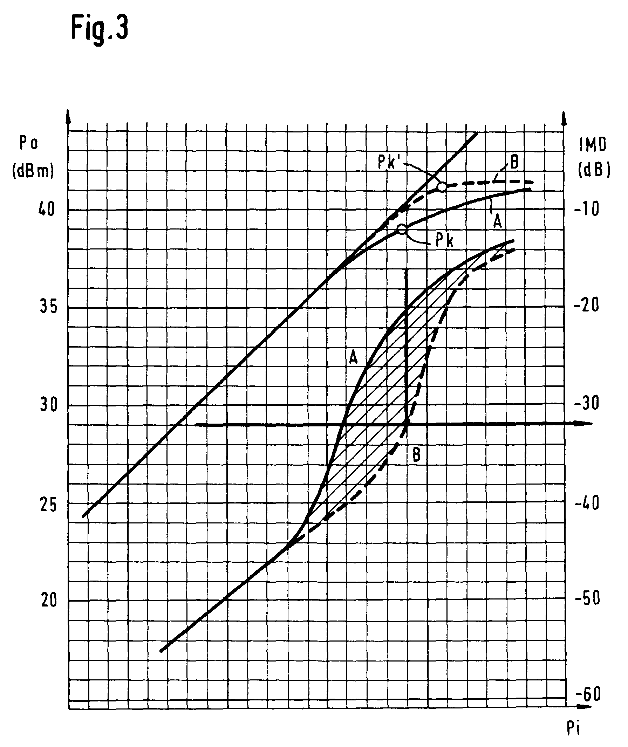

In Figur 3 ist die normale Kennlinie A des Verstärkers V1 mit dem 1dB-Kompressionspunkt Pk ohne Einsatz des Vorverzerrers VVZ dargestellt. Mit Einsatz des Vorverzerrers VVZ verschiebt sich der 1dB-Kompressionspunkt Pk in Richtung Sättigung, wie die strichlierte Kennlinie B verdeutlicht. Der lineare Bereich des Verstärkers vergrößert sich also dadurch. Entsprechend erhöht sich der Intermodulationsabstand IMD, wie der Vergleich zwischen der Kurve A ohne Vorverzerrer und der Kurve B mit Vorverzerrer im unteren Bereich der Fig.3 verdeutlicht.

Betrag und Phase des Fehlersignals f1 werden über das variable Dämpfungsglied D2 und das variable Phasenglied P2 adaptiv so nachgeführt, daß es zu einer größtmöglichen Kompensation der Intermodulationsprodukte im Ausgangssignal a1 des Verstärkers V1 am Koppler K6 kommt. Eine zweite Steuereinheit ST2 steuert das Dämpfungsglied D2 und das Phasenglied P2 in dem genannten Sinn. Dazu wird für die Steuereinheit ST2 eine Regelgröße aus einem Signalanteil a21 abgeleitet, das über die Koppler K7 und K8 aus dem linearisierten Ausgangssignall a2 ausgekoppelt wird. In einem anschließenden Koppler K9 wird die Differenz zwischen dem Ausgangssignalanteil a21 und einem Eingangssignalanteil e11, der von einem Koppler K3 aus dem Eingangssighal e1 ausgekoppelt wird, gebildet. Das Differenzsignal d1 am Ausgang des Kopplers K9 soll einen möglichst geringen Nutzsignalanteil enthalten, so daß das Differenzsignal d1 möglichst weitgehend durch die im linearisierten Ausgangssignal a2 noch vorhandenen Intermodulationsprodukte bestimmt wird. Ein Laufzeitglied L2 in der Leitung des Eingangssignalanteils e11 sorgt dafür, daß der Koppler K9 die beiden Signalanteile e11 und a21 zeitrichtig überlagert. Das Differenzsignal d1 wird in einem Mischer Mx mit der Frequenz eines Oszillators LO in eine Zwischenfrequenz herabgemischt. Das so entstandene Signal d2 wird anschließend einem Spektrumdetektor SD zugeführt, wie er beispielsweise aus Fujitsu SCI Tech. J., 22, 4, Sept.1986, Seite 294 bis 306 bekannt ist. Die Intermodulationsprodukte treten hauptsächlich in den seitlich des Hauptspektrums des Nutzsignals liegenden Nebenspektren auf. Deshalb selektiert der Spektrumdetektor SD die seitlichen Spektren des in den Zwischenfrequenzbereich herabgemischten Differenzsignals d2. Die Steuereinheit ST2 steuert nun das Dämpfungsglied D2 und das Phasenglied P2 für das Fehlersignal f1 so, daß die seitlichen Spektralanteile des Differenzsignals D2 minimal werden. Dadurch wird erreicht, daß im Koppler K6 das Fehlersignal betrags- und phasenmäßig so dem nicht linearisierten Ausgangssignal a1 des Verstärkers V1 überlagert wird, daß es die Intermodulationsprodukte in dem Signal a1 optimal kompensiert.

Das Differenzsignal d1 am Ausgang des Kopplers K9 soll nach Möglichkeit keine Nutzsighalanteile mehr enthalten, damit es, wie bereits oben gesagt, möglichst weitgehend von den Intermodulationsprodukten im Ausgangssignal a2 bestimmt ist. Die Unterdrückung des Nutzsignals durch die Differenzbildung im Koppler K9 wird dann optimal, wenn der Eingangssignalanteil e11 und der Ausgangssignalanteil a21 betrags- und phasenmäßig möglichst genau aneinander angepaßt sind. Zu diesem Zweck wird der Ausgangssignalanteil a21 über einen variablen Phasenschieber P3 und ein variables Dämpfungsglied D3 geführt. Die Steuereinheit ST2 stellt das Dämpfungsglied D3 und das Phasenglied P3 so ein, daß das Differenzsignal d2 minimiert wird. Dann kann davon ausgegangen werden, daß der Einfluß des Nutzsignals im Differenzsignal d2 verschwindend gering ist und es fast ausschließlich die Intermodulationsprodukte des Ausgangssignals a2 enthält.

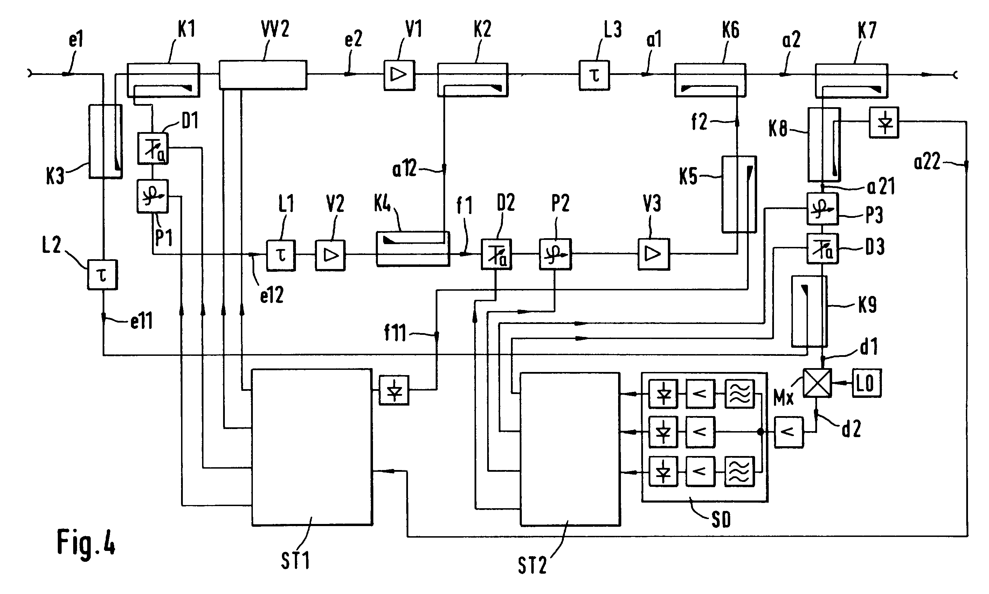

In der Figur 4 ist eine Schaltung angegeben, die sich gegenüber dem Ausführungsbeispiel in Figur 1 durch folgende Maßnahmen unterscheidet. Der Eingangssignalanteil e12, der zur Gewinnung des Fehlersignals f1 herangezogen wird, wird über einen Verstärker V2 linear verstärkt, wodurch sich ein größerer Pegel für das Fehlersignal f1 ergibt. Außerdem kann dieser Verstärker V2 den Temperaturgang der Verstärkung des Verstärkers V1 kompensieren. Die vom Fehlersignalverstärker aufzubringende Verstärkung kann deswegen kleiner sein, wodurch seine Verzögerungszeit ebenfalls kleiner wird. Demzufolge braucht auch das Laufzeitglied L3 keine so große Zeitverzögerung bewirken, wodurch seine Einfügungsdämpfung kleiner wird.

Der Fehlersignalanteil f11 als Regelgröße für die erste Steuereinheit ST1 kann auch über den Koppler K5 am Ausgang des Fehlersignalvestärkers V3 ausgekoppelt werden.

In den vorangehend beschriebenen Ausführungsbeispielen ist von zwei Steuereinheiten ST1 und ST2 die Rede. Die Funktionen beider Steuereinheiten ST1 und ST2 können natürlich auch von einer einzigen Steuereinheit ausgeführt werden.

Nachfolgend wird die Funktionsweise der Steuergeräte ST1, ST2 genauer beschrieben. Dabei wird hier davon ausgegangen, daß ein einziges Steuergerät die Funktionen der in den Ausführungsbeispielen getrennt dargestellten Steuergeräte ST1 und ST2 ausführt.

Genaugenommen muß bei der Arbeitsweise der Steuereinheit unterschieden werden zwischen dem Einmessen der Schaltung im Prüffeld und dem realen Betrieb der Schaltung. Im Prüffeld sind zunächst konstante Startwerte für den Vorverzerrer VVZ, die Dämpfungsglieder D1, D2, D3 und für die Phasenglieder P1, P2 und P3 zu gewinnen.

Zur Gewinnung der Startwerte ist folgender Verfahrensablauf erforderlich. Das Eingangssignal e1 sei beispielsweise ein QAM-Signal:
1. Die Verstärker V1 und V2 werden abgeschaltet.
2. Die Leistung des Eingangssignals e1 wird soweit erhöht, bis das Ausgangssignal a2 des Verstärkers V1 die Nennleistung erreicht hat.
3. Durch Verstellen des Dämpfungsgliedes D3 wird der aus dem Ausgangssignal a2 des Verstärkers V1 ausgekoppelte Signalanteil a21 soweit verringert, bis die vom Spektrumdetektor SD detektierten Intermodulationsprodukte ein Minimum erreichen. Anschließend wird dieselbe Prozedur durch Verstellung des Phasengliedes P3 durchgeführt, bis die Intermodulationsprodukte minimal werden. Die Einstellungen des Dämpfungsglieds D3 und des Phasengliedes P3 bei Erreichen minimaler Intermodulationsprodukte werden abgespeichert.
4. Der Vorverzerrer VVZ wird so eingestellt, daß ebenfalls die vom Spektrumdetektor SD detektierten Intermodulationsprodukte ein Minimum erreichen. In diesem Fall hat der Vorverzerrer VVZ den Verstärker V1 so gut linearisiert, daß die nichtlinearen Anteile im Fehlersignal f1 ein Minimum sind. Die Einstellparameter für den Vorverzerrer VVZ werden abgespeichert.
5. Der Verstärker V2 wird eingeschaltet. Anschließend wird bei einem um ca. 10 dB abgesenkten Eingangssignalpegel e1 mit dem Dämpfungsglied D1 und dem Phasenglied P1 der aus dem Fehlersignal f1 ausgekoppelte Signalanteil f11 auf ein Minimum eingestellt. Dieses Minimum wird hier eindeutig durch die gegenphasige Addition der Signalanteile e12 und a12 erreicht. Der Vorverzerrer VVZ erhält einen um 10 dB niedrigeren Eingangspegel und macht damit keine Expansionen mehr. Die vorhandenen Intermodulationsprodukte sind hier wesentlich kleiner und haben keinen Einfluß auf den Ablauf. Die Einstellparameter für das Dämpfungsglied D1 und das Phasenglied P1 werden abgespeichert.
6. Die Leistung des Eingangssignals e1 wird wieder so weit erhöht, bis das Ausgangssignal a2 des Verstärkers V1 die Nennleistung erreicht.
7. Der Verstärker V3 wird eingeschaltet und über entsprechende Einstellungen des Dämpfungsgliedes D2 und des Phasengliedes P2 werden die Nebenspektren am Ausgang des Spektrumdetektors SD auf möglichst gleiches Minimum eingestellt. Sowohl eine Amplitudenschräglage als auch ein Phasengang (verursacht durch kleine auch stark bedämpfte Resonanzen) können die Ursache dafür sein, daß die beiden Nebenspektren nicht die gleiche Amplitude haben.
8. Alle zuvor gewonnenen Einstellparameter werden in einem nichtflüchtigen Speicher abgelegt (z. B. Eprom), damit diese später als Startwert von einem Controller in der Steuereinheit verwendet werden können.

Im Betriebsfall der Schaltung werden zunächst die abgespeicherten Startwerte vom Controller der Steuereinheit eingestellt. Dann wird über ein Programm eine ständige Optimierung adaptiv durchgeführt. Dabei ist folgender Verfahrensablauf zweckmäßig:
1. Durch feinstufiges Ändern des Dämpfungsgliedes D3 und des Phasengliedes P3 wird das Differenzsignal d1 bzw. d2 auf ein Minimum eingestellt.
2. Ist die Leistung des Signals a2 mindestens 6 dB kleiner als die Nennleistung, dann wird durch Verstellen des Dämpfungsgliedes D1 und des Phasengliedes P1 der aus dem Fehlersignal f1 ausgekoppelte Fehlersignalanteil f11 auf ein Minimum eingestellt.
3. Ist die Leistung des Signals a2 gleich der Nennleistung oder weniger als um 6 dB gegenüber der Nennleistung abgesenkt, dann wird durch zyklisches Verändern des Dämpfungsgliedes D2 und des Phasengliedes P2 ein Minimun der Intermodulationsprodukte am Ausgang des Spektrumdetektors SD eingestellt.
4. Die Einstellung des Vorverzerrers VVZ wird geringfügig geändert und dann versucht, mit dem Dämpfungsglied D2 und dem Phasenglied P2 den Intermodulationsabstand zu vergrößern. Ist das Ergebnis schlechter, dann muß die Einstellung umgekehrt werden. Mit einer Änderung am Vorverzerrer VVZ kann man erst dann etwas erreichen, wenn der Verstärker V3 soweit ausgesteuert wird, daß die Verzerrungsbeiträge durch den Spektrumdetektor SD meßbar werden. Dann können diese Beiträge durch eine bessere Einstellung des Vorverzerrers VVZ reduziert werden.
5. Da überwiegend nur eine reduzierte Leistung des Ausgangssignals a2 erforderlich ist, kann die erste Regelschleife mit dem Dämpfungsglied D1 und dem Phasenglied P1 sowie die zweite Regelschleife mit dem Dämpfungsglied D2 und dem Phasenglied P2 immer wieder optimiert werden. Der Vorverzerrer VVZ muß erst dann optimal eingestellt werden, wenn die Verstärkerstufen des Verstärkers V1 enger dimensioniert sind. Aber dann liefern sie auch größerer Verzerrungsbeiträge, die wiederum besser meßbar sind.

## Patentansprüche

1. Schaltung zur Linearisierung eines Verstärkers, welcher einen Fehlersignalvestärker aufweist, der ein aus dem Ein- und dem Ausgangssignal des Verstärkers abgeleitetes Fehlersignal verstärkt, das dem Ausgangssignal zur Kompensation der darin enthaltenen Intermodulationsprodukte überlagert wird, dadurch gekennzeichnet, daß dem Verstärker (V1) ein Vorverzerrer (VVZ) vorgeschaltet ist und daß eine Steuereinheit (ST1) vorhanden ist, die beim Betrieb des Verstärkers (V1) im nichtlinearen Aussteuerbereich den Vorverzerrer (VVZ) in Abhängigkeit vom Fehlersignal (f1) so einstellt, daß das Fehlersignal (f1) minimal wird.

2. Schaltung nach Anspruch 1, dadurch gekennzeichnet, daß Mittel (K1) vorhanden sind, die aus dem Eingangssignal (e1) und aus dem Ausgangssignal (a1) des Verstärkers (V1) jeweils einen Signalanteil (e12, a12) auskoppeln und daß die Differenz zwischen dem Ausgangssignalanteil (a12) und dem Eingangssignalanteil (e12) das Fehlersignal (f1) darstellt.

3. Schaltung nach Anspruch 1 oder 2, dadurch gekennzeichnet, daß die Steuereinheit (ST1) beim Betrieb des Verstärkers (V1) im linearen Aussteuerbereich den Betrag und die Phase des Eingangssignalanteils (e12) in Abhängigkeit von der Differenz zwischen dem Ausgangs- (a12) und dem Eingangssignalanteil (e12) des Verstärkers (V1) so einstellt, daß der Nutzsignalanteil in dem Differenzsignal (f1) möglichst gering ist.

4. Schaltung nach Anspruch 1, dadurch gekennzeichnet, daß eine Steuereinheit (ST2) den Betrag und die Phase des Fehlersignals (f1) so einstellt, daß es durch Überlagerung des Fehlersignals (f1) mit dem Ausgangssignal (a1) des Verstärkers (V1) zu einer größtmöglichen Kompensation der Intermodulationsprodukte im Ausgangssignal (a1) kommt, und daß die zweite Steuereinheit (ST2) den Betrag und Phase des Fehlersignals (f1) in Abhängigkeit von der Differenz (d1) zwischen einem vom Eingangssignal (e1) des Verstärkers (V1) ausgekoppelten Signalanteil (e11) und einem vom Fehler-kompensierten Ausgangssignal (a2) des Verstärkers (V1) ausgekoppelten Signalanteil (a21) einstellt.

5. Schaltung nach Anspruch 4, dadurch gekennzeichnet, daß die Steuereinheit (ST2) den Betrag und die Phase des vom fehler-kompensierten Ausgangssignal (a2) ausgekoppelten Signalanteils (a21) so einstellt, daß der Nutzsignalanteil in dem Differenzsignal (d1) möglichst gering ist.

6. Schaltung nach einem der Ansprüche 4 oder 5, dadurch gekennzeichnet, daß ein Mischer (Mx) das Differenzsignal (d1) in eine Zwischenfrequenzebene heruntermischt und daß dieses Signal (d2) über einen Spektrumdetektor (SD) zur Selektion von Spektralanteilen zu beiden Seiten des Nutzsignalspektrums an die Steuereinheit (ST2) gelangt.
